# EUROPEAN PATENT SPECIFICATION

(11) **EP 3 296 760 B1**
(45) Date of publication and mention of the grant of the patent: **19.05.2021**
(21) Application number: 17192256.0
(22) Date of filing: 20.09.2017
(51) Int. Cl.: G01S 7/40, G01R 29/10

(54) **METHOD AND SYSTEM FOR TESTING RADAR SYSTEMS**
VERFAHREN UND SYSTEM ZUM TESTEN VON RADARSYSTEMEN
PROCÉDÉ ET SYSTÈME DE TEST DE SYSTÈMES RADAR

(30) Priority: 20.09.2016 IT 201600094409
(43) Date of publication of application: 21.03.2018
(73) Proprietor: LEONARDO S.p.A., 00195 Roma (IT)
(72) Inventor: BISOGNI, Emanuele, 00131 Roma (IT); VACCA, Emanuele, 00131 Roma (IT); MENNA, Roberto, 00131 Roma (IT); PAGLIAI, Stefano, 00131 Roma (IT); STRAPPAVECCIA, Sandro, 00131 Roma (IT); FARINA, Alfonso, 00131 Roma (IT); ROSELLI, Antonia, 00131 Roma (IT); CUCINOTTA, Paolo, 00131 Roma (IT)
(74) Representative: Bergadano, Mirko

(56) References cited:
- WO-A1-2018/011077
- US-A- 5 164 734
- US-A1- 2005 128 136
- US-A1- 2016 088 498

## Description

### TECHNICAL FIELD OF THE INVENTION

The present invention relates, in general, to a method and a system for testing radar systems, such as (ground-based) air defense radar systems and ship-based long-range radar systems. In particular, the present invention concerns a method and a system for testing radar systems' capability to detect and track remote non-linear moving targets, such as ballistic missiles.

### STATE OF THE ART

Nowadays, air defense radar systems are widely used, as early-warning systems, to detect and track air threats. As it is known, many of the air defense radar systems currently in use are based on three-dimensional (3D) radar sets designed to provide 3D tracks (i.e., 3D positions and 3D velocities) of detected targets, which 3D tracks are generally expressed in terms of range, azimuth and elevation (or height).

One of the main functions of an air defense radar system is represented by anti-tactical ballistic missile (ATBM) defense. In this respect it is worth noting that recently the ATBM function is becoming a key feature also for ship-based long-range radar systems.

Clearly, ATBM capabilities of air defense radar systems require to be tested both during first acceptance phase and periodically in order to verify tactical ballistic missile (TBM) detection, identification and tracking performance of said systems.

Generally speaking, the verification of ATBM performance of a radar system typically requires generation of signals emulating echoes of real threats buried in an electromagnetic scenario characterized by noise, clutter and air-traffic-related signals.

In particular, in order to assess the response of a radar system to sudden threats such as the unpredictable launch of a TBM, different techniques are nowadays used, such as techniques based on the use of:
- radar environment simulators (RESs) designed to simulate electronic countermeasure (ECM) environments (i.e., electromagnetic scenarios involving electromagnetic interference and one or more simulated targets), typically by injecting intermediate frequency (IF) test signals directly into the IF processing chain of a radar system under test (UT) so as to check its operation;
- a radar repeater arranged at a given fixed distance from a radar system UT and designed to receive radar pulses transmitted by the radar system UT, delay and attenuate the received radar pulses, and transmit the delayed and attenuated radar pulses towards the radar system UT so as to simulate radar echoes of a target at fixed range, azimuth and elevation; or
- antenna test facilities, such as near-field antenna test ranges, in which radar systems to be tested have to be placed and wherein radar repeaters are mechanically moved to predefined fixed positions and, for each predefined fixed position, operated to simulate targets' radar echoes.

The test techniques based on the use of RESs are flexible and useful, and allow radar operators to periodically check performance of radar systems.

Unfortunately, with the use of a RES, since the test signals are typically injected at IF level, the radio frequency (RF) processing chain (including the antenna) of a radar system UT is not tested (i.e., operation of the radar system UT, from the RF front-end up to the IF processing chain, is not involved in the test and, hence, is not evaluated). Therefore, the results of a test campaign can be considered positive only by assuming nominal performance for the non-tested RF components of the radar system UT.

On the contrary, the test techniques based on the use of fixed radar repeaters have the advantage of involving also the RF processing chain in the test. Moreover, these test techniques are very reliable and allow to perform tests in the field. Unfortunately, these test techniques necessarily entail that, during a test, a radar system UT must be always kept aimed at the fixed location of the radar repeater used for the test, and this is a limitation on the ATBM capability evaluation. In fact, in order for a full evaluation in a real scenario to be performed, a radar system should be tested under normal operation conditions.

An example of radar testing based on the use of fixed radar repeaters is provided in US 5,164,734 A, that discloses an active radar target device containing a means receiving a radar signal, a means for decreasing the frequency of the radar signal received, at least one means for delaying the reduced frequency radar signal, means for increasing the frequency of the delayed signal, and means of modulating the delayed signal. The modulated and delayed signal is transmitted to an antenna, from which it may be radiated to a radar detector.

In particular, with specific reference to figure 7 and to related description from column 13, line 21, up to column 14, line 4, of US 5,164,734 A, a tactical radar training system is disclosed, which is adapted to simulate the approach of a single high-speed, low-altitude threat aircraft, or the simultaneous approach of several aircraft, or the approach of one or more slower moving helicopters, and which is intended to train radar operators without the need to fly aircraft against a radar system UT.

Said tactical radar training system includes a tactical radar system to be tested, a multiplicity of active radar targets of the aforesaid type, and a remote data link. Each active radar target is fixedly arranged at a respective fixed position (i.e., at respective fixed range, azimuth and elevation) in a coverage region of said tactical radar system to be tested. The remote data link is operatively connected to the active radar targets to operate said radar targets to simulate multiple approaching threat aircraft, singly or simultaneously. In particular, each active radar target is operated so as to simulate a radial path, i.e., an aircraft (or another moving object) approaching the radar UT at a constant azimuth angle and a constant elevation angle.

As for the test techniques based on the use of antenna test facilities, these test techniques are very effective but applicable only during characterization and calibration of radar antennas. In particular, with these test techniques, the ATBM capability of a radar system can be evaluated only in a laboratory environment and, hence, not in real scenarios.

Moreover, the results obtainable by the test techniques based on the use of antenna test facilities are strongly limited by the poor geometry of the mechanical frame used to move the radar repeaters. This generally results in a lack of test flexibility and an inability to simulate all possible trajectories of a TBM (e.g., with these test techniques it is possible to simulate only radial trajectories of a TBM).

With reference to a different technical field, i.e., characterization of antenna radiation patterns, US 2016/088498 A1 describes an unmanned aerial vehicle (UAV) for antenna radiation characterization, which has a propulsion system and a transceiver. Control signals are transmitted from a base station to position the UAV adjacent an antenna of interest. The UAV for antenna radiation characterization further includes a signal strength antenna for receiving an antenna signal generated by the antenna of interest for calculating or determining the received signal strength of the antenna signal. A received signal strength signal is then transmitted back to the base station, in real time. The received signal strength signal is representative of a set of received signal strengths of the antenna signal corresponding to a set of three-dimensional measurement coordinates such that the received signal strength signal represents a three-dimensional radiation pattern associated with the antenna of interest.

In particular, with specific reference to figures 1, 2 and 3 and to paragraphs [0014]-[0026] of US 2016/088498 A1, a UAV is equipped with a a signal strength antenna and is used to fly in an area around a stationary antenna to collect data (specifically, to sense and map received signal strength of signals transmitted by the stationary antenna) for three-dimensional characterization of the antenna signal (i.e., in order to determine radiation characteristics and shape) of said stationary antenna.

In detail, in use, the UAV flies in a path about the stationary antenna (located in its normal location) to take measurements of received signal strength (RSS) about said stationary antenna in order to map or characterize the antenna signal in three dimensions about said stationary antenna US 2005/0128136 A1 discloses radar calibration and radar operator training with a UAV as target.

### OBJECT AND SUMMARY OF THE INVENTION

A general object of the present invention is that of providing a method and a system for testing radar systems' capability to detect and track remote non-linear moving targets, such as ballistic missiles, which method and system allow to overcome, at least in part, the above technical drawbacks of the current test techniques.

In particular, a specific object of the present invention is that of providing a method and a system which:
- allow to test the full receiving and processing chain of a radar system UT;
- allow to test the ATBM function without altering the normal beam pointing and the normal operation of the radar system UT;
- provide a full flexibility in generating different trajectories of different types of TBMs;

- provide reliable results; and
- allow to perform low-cost test campaigns.

Moreover, a further specific object of the present invention is that of providing a reliable test technology for simulating TBM launches and for checking, evaluating and improving ATBM capability of modern 3D radar systems.

These and other objects are achieved by the present invention in that it relates to a method and a system for testing radar systems' capability to detect and track targets, as defined in the appended claims.

In particular, the present invention stems from Applicant's idea of simulating a faraway trajectory of a non-linear moving target (such as a TBM) flying at a distance of hundreds of kilometers from the antenna of a radar system UT by means of:
- a drone following a closer trajectory that has the same azimuth and elevation characteristics as the simulated faraway trajectory (e.g., a drone flying at a distance of hundreds of meters from the antenna of the radar system UT with the same azimuth and elevation characteristics as the non-linear moving target distant hundreds of kilometers); and
- a radar repeater transmitting, from the drone, radar signals emulating radar echoes originated from the non-linear moving target distant hundreds of kilometers from the antenna of the radar system UT.

In detail, the present invention relates to a method for testing radar systems' capability to detect and track targets, said method including:
- defining a first non-linear trajectory of a non-linear moving target to be simulated, wherein said first non-linear trajectory comprises a sequence of first positions, each defined by respective range, azimuth and elevation with respect to an antenna of a radar system UT;
- defining a kinematic model of the non-linear moving target to be simulated;
- computing a second non-linear trajectory based on the first non-linear trajectory, wherein said second non-linear trajectory comprises a sequence of second positions, each of which is
   - defined by respective range, azimuth and elevation with respect to the antenna of the radar system UT,
   - associated with a corresponding first position that is defined, with respect to the antenna of the radar system UT, by the same azimuth and elevation as said second position and by a greater range than said second position, and
   - associated with a corresponding time at which the non-linear moving target is located at the corresponding first position associated with said second position, wherein said corresponding time is computed based on the kinematic model;
- providing a drone equipped with an on-board antenna for receiving radar signals transmitted by the antenna of the radar system UT;
- flying the drone by
   - following the second non-linear trajectory, and
   - causing said drone to be located at each second position at the corresponding time associated with said second position; and,
- when the drone is located at one of the second positions,
   - processing an incoming radar signal received by the on-board antenna at said second position so as to generate a processed radar signal simulating a radar echo from the non-linear moving target located at the corresponding first position associated with said second position, and
   - transmitting the processed radar signal by the on-board antenna from said second position towards the antenna of the radar system UT;
wherein flying the drone includes:
- allowing a user to select a flight mode for the drone from among a continuous flight mode and a stop-and-go flight mode;
- if the continuous flight mode is selected, causing the drone to follow continuously the second non-linear trajectory;
- if the stop-and-go flight mode is selected, causing the drone to reach, and stop at, each second position.

### BRIEF DESCRIPTION OF THE DRAWINGS

For a better understanding of the present invention, preferred embodiments, which are intended purely by way of non-limiting examples, will now be described with reference to the attached drawings (all not to scale), wherein:
- Figure 1 shows a right triangle schematically representing a trajectory of a target observed by a radar system under a given elevation angle;
- Figure 2 schematically illustrates a projection of a faraway TBM trajectory onto a plane close to a 3D radar antenna maintaining the same azimuth and elevation characteristics;
- Figure 3 schematically illustrates a first test system according to a first preferred embodiment of the present invention;
- Figure 4 schematically illustrates a second test system according to a second preferred embodiment of the present invention;
- Figure 5 schematically illustrates an example of trajectory intended to be followed by a drone to simulate a non-linear trajectory of a remote non-linear moving target according to an aspect of the present invention; and
- Figure 6 schematically illustrates an example of architecture of a component of the second test system shown in Figure 4.

### DETAILED DESCRIPTION OF PREFERRED EMBODIMENTS OF THE INVENTION

The following discussion is presented to enable a person skilled in the art to make and use the invention. Various modifications to the embodiments will be readily apparent to those skilled in the art, without departing from the scope of the present invention as claimed.

The present invention stems from Applicant's idea of looking in perspective at real TBM trajectories, that typically extend for hundreds of kilometers at distances of hundreds of kilometers from a radar antenna and that have projections becoming "smaller" onto planes closer to the radar antenna.

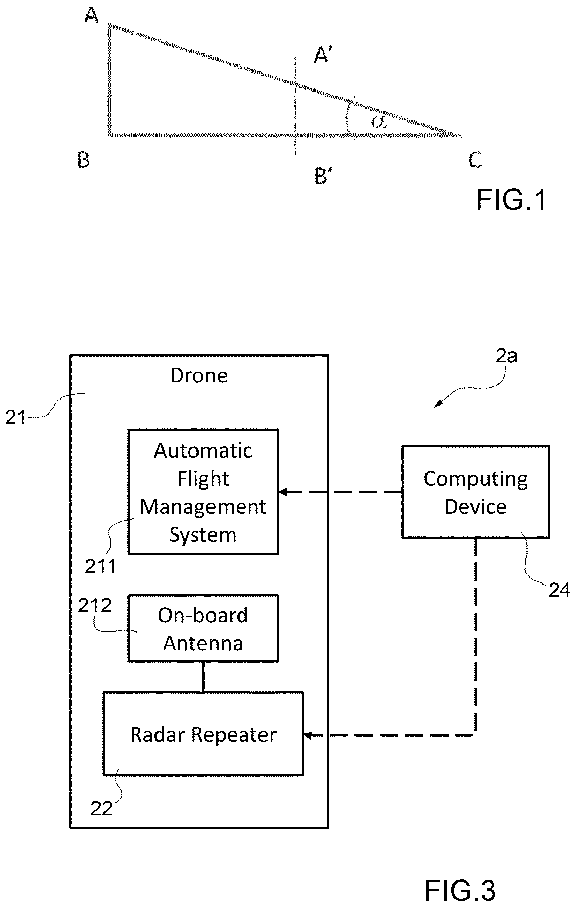

For a better understanding of the idea underlying the present invention, reference is made to Figure 1, that shows a right triangle having vertices A, B and C, a hypotenuse AC extending between the vertices A and C, and catheti BC and AB extending between the vertices B and C, and A and B, respectively, with the cathetus BC that is longer than the cathetus AB.

In particular, the cathetus AB can be considered as a trajectory (or a portion thereof) followed by a TBM and observed by a radar located at vertex C under an elevation angle α.

Figure 1 shows also a line segment parallel to the cathetus AB which intersects the hypotenuse AC at a point A' and the cathetus BC at a point B'.

Obviously, the following trigonometric relations apply:
- *AB* = *AC* sin(*α*) ;
- *A'B'* = *A'C* sin(*α*) ;
- *BC* = *AC* cos(*α*); and
- *B'C* = *A'C* cos(*α*).

Moreover also the following mathematical relations apply:
- *B'C* < *BC* and *A'C* < *AC;* and thence
- *A'B'*< *AB.*

In other words, the Applicant has noticed that, while a real TBM is following a parabolic ballistic trajectory with launch and impact points (LP and IP) typically distant 50-700 Km and with apogee reaching the height of 70-250 Km, the corresponding projection of this ballistic trajectory onto a plane at a few hundred meters from the radar antenna is still a parabolic trajectory with substantially the same azimuth and elevation characteristics as said ballistic trajectory and with LP and IP distant tens of meters (e.g., 20-100 m) and apogee with height of a few hundred meters (e.g., 100-400 m).

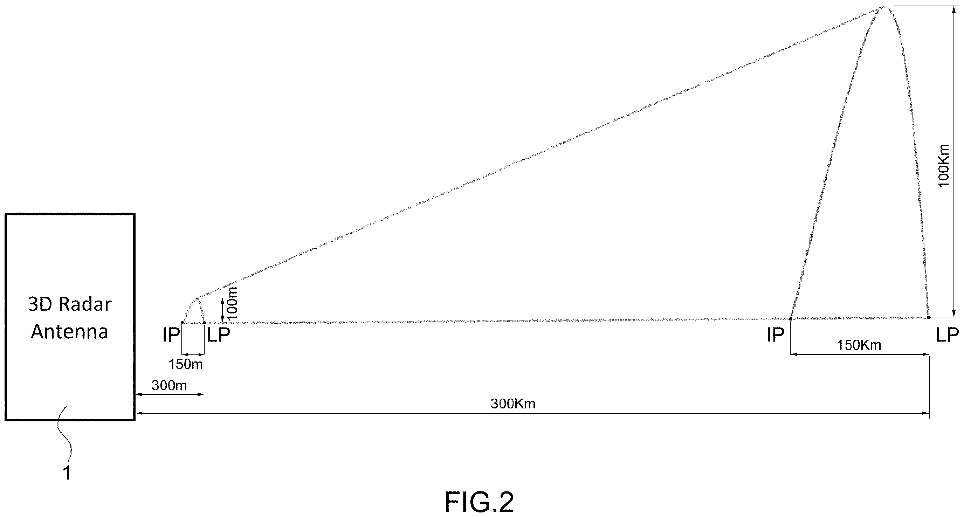

In this connection, reference can be made to Figure 2, which schematically shows a projection of a faraway TBM trajectory onto a plane close to a 3D radar antenna 1. In particular, said faraway TBM trajectory has a LP 300 Km far away from the 3D radar antenna 1, a distance between LP and IP of 150 Km, and an apogee with height of 100 Km, while its projection has a LP 300 m far away from the 3D radar antenna 1, a distance between LP and IP of 150 m and an apogee with height of 100 m, and maintains the same azimuth and elevation characteristics as the real TBM trajectory.

From a kinematic point of view, also the vertical and radial speeds of a TBM are downscaled in the proximity of a radar antenna, where the kinematic characteristics of a TBM ascending for hundreds of kilometers with vertical speed in the order of kilometers per second are fully within the performance capability and the flight envelope of, and thence can be reproduced by, commercial off-the-shelf (COTS) UAVs (also commonly known as drones), such as COTS multicopter (or multirotor) drones.

Accordingly, a UAV (or drone), such as a multicopter drone, may be advantageously exploited to simulate trajectories of TBMs (or, more in general, of non-linear moving targets distant hundreds of kilometers) at a few hundred meters from the radar antenna.

Thence, according to the present invention, in order to test capability of a radar system to detect and track remote non-linear moving targets, such as TBMs, a drone (conveniently a multicopter drone) is operated to follow a predefined trajectory having the same azimuth and elevation characteristics as a faraway trajectory of a simulated non-linear moving target, such as a TBM.

In this respect, it is to be noted that, when the drone moves within the blind region (due to the so-called blind range) of the radar system UT, said drone is not detected by the radar system UT. Therefore, in order for the drone to be detected, the latter is equipped with an antenna (conveniently a dipole antenna) connected to a radar repeater (such as a far-field repeater), that is configured to:
- detect the radar pulses transmitted by the radar system UT;
- delay the received radar pulses by time delays related to predefined range distances of a simulated target and attenuate the delayed radar pulses by attenuation amounts related to the predefined range distances of the simulated target; and
- transmit the delayed and attenuated radar pulses towards the radar system UT by means of the antenna on board the drone.

Therefore, the technique according to the present invention allows to simulate a TBM trajectory whose azimuth and elevation characteristics are provided (i.e., simulated) by the kinematic evolution of the drone, while the range distances are simulated by the radar repeater.

In other words, the combination of the spatial position of the drone with the suitably delayed and attenuated radar pulses provided by the radar repeater allows to generate signals that, for the radar system UT, are equivalent, in azimuth, elevation and range, to the echoes generated by a real TBM flying at hundreds of kilometers from the radar system UT.

Conveniently, two architecture options are available for the radar repeater; namely, the radar repeater can be installed directly on board the drone, or it can be placed on the ground and connected to the antenna on board the drone by means of a wired or wireless connection. Both options have pros and cons that should be carefully balanced in order to determine the most suitable solution for the radar tests to be performed.

In particular, with the first architecture option (i.e., with the radar repeater installed on board the drone), radar repeater's weight has an impact on the maximum height of flight as well as on the profile and duration of the drone's mission. Moreover, in this case it is necessary to store in advance (i.e., before the execution of a drone's mission), on the radar repeater, the delay and attenuation values that are related to the trajectory to be simulated and that, during the drone's mission, will be applied by the radar repeater to the radar signals received from the radar system UT.

On the contrary, with the second architecture option (i.e., with the radar repeater placed on the ground and connected to the antenna on board the drone), radar repeater's weight does not have any impact on the drone's mission, but the connection between the radar repeater and the antenna on board the drone may adversely affect the drone's mission profile. In particular, a wired connection may adversely affect drone's freedom of maneuver and also pointing of the antenna on board the drone. Thence, a wireless connection may be preferable. In this latter case, both the drone and the radar repeater are conveniently equipped with wireless communication means.

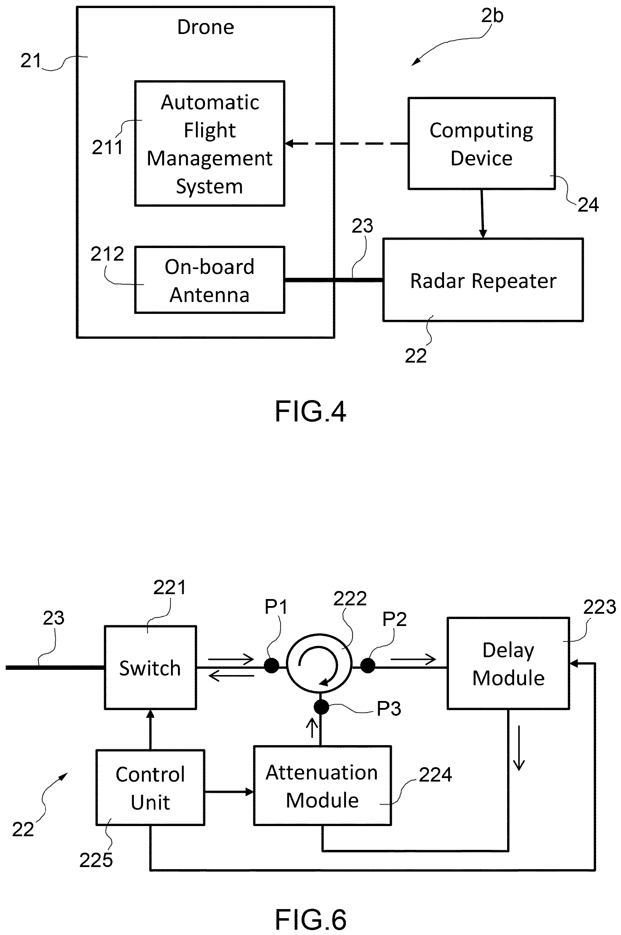

In this respect, Figure 3 schematically shows a first test system 2a according to a first preferred embodiment of the present invention based on the above first architecture option, while Figure 4 schematically shows a second test system 2b according to a second preferred embodiment of the present invention based on the above second architecture option and on the use of a wired connection.

In particular, as shown in Figures 3 and 4, both the test systems 2a and 2b include:
- a drone 21 (such as a multicopter drone) equipped with an automatic flight management system 211 and an on-board antenna 212;
- a radar repeater 22, that is connected to the on-board antenna 212 and that,
   - in the first preferred embodiment shown in Figure 3, is installed on board the drone 21, while,
   - in the second preferred embodiment shown in Figure 4, is not installed on board the drone 21, but is remotely connected to the on-board antenna 212 by means of an optical fiber cable 23 and is intended to be placed on the ground during operation of the second test system 2b; and
- a computing device 24 (such as a laptop or tablet).

More in detail, the computing device 24 is programmed to:
- define a first trajectory (preferably a non-linear trajectory, such as a TBM trajectory) to be simulated, wherein said first trajectory comprises a sequence of first positions, each of which is defined by respective range, azimuth and elevation with respect to an antenna of a radar system UT (not shown in Figures 3 and 4);
- compute a second trajectory related to the first trajectory to be simulated, wherein said second trajectory comprises a sequence of second positions, each of which is
   - defined by respective range, azimuth and elevation with respect to the antenna of the radar system UT, and
   - associated with a corresponding first position along the first trajectory, which corresponding first position is defined, with respect to the antenna of the radar system UT, by the same azimuth and elevation as said second position and by a greater range than said second position; and
- load/store the computed second trajectory on the automatic flight management system 211.

Conveniently, the second trajectory computation, used to evaluate the second positions, takes into account all kinematic effects to which the remote non-linear moving target to be simulated (such as a TBM) is subjected, (e.g., drag force, booster thrust, Coriolis force, etc.).

The drone 21 is operable to follow said second trajectory. In particular, the automatic flight management system 211 is configured to cause the drone 21 to follow the loaded/stored second trajectory by flying said drone 21 to each of said second positions.

Conveniently, the computing device 24 is programmed to compute and then load/store on the automatic flight management system 211 a drone mission program including a time profile of the second trajectory (i.e., predefined times and corresponding second positions to be occupied by the drone 21 at said predefined times).

Preferably, the drone 21 is equipped with a global navigation satellite system (GNSS) receiver (not shown in Figures 3 and 4 for the sake of illustration simplicity), such as a Global Positioning System (GPS) or Galileo receiver, to monitor and control bearing, height, latitude and longitude of said drone 21 with respect to time profile of the drone's mission (i.e., the time profile of the second trajectory).

Conveniently, the GNSS receiver installed on board the drone 21 is configured to implement a real time kinematic (RTK) satellite navigation technique to enhance precision and accuracy of computation of the position of the drone 21.

Moreover, the GNSS receiver, in addition to the position of the drone 21, provides also a time reference expressed in Coordinated Universal Time (UTC) that can be conveniently used for the synchronization with the radar system UT.

More preferably, the drone 21 is equipped also with an altimeter and a compass (not shown in Figures 3 and 4 for the sake of illustration simplicity) to further improve control of bearing and height of said drone 21.

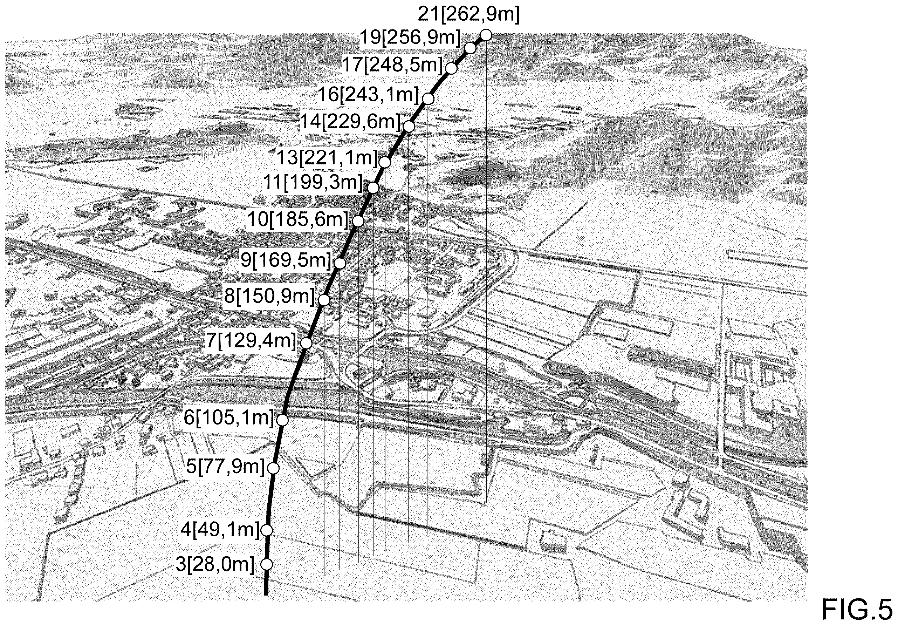

Figure 5 schematically illustrates an example of second trajectory computed by the computing device 24 and intended to be followed by the drone 21 to simulate a corresponding first trajectory of a remote non-linear moving target, such as a TBM. In particular, Figure 5 shows the sequence of second positions of the second trajectory to be occupied by the drone 21.

Again with reference to Figures 3 and 4, the radar repeater 22 is designed to:
- receive, from the on-board-antenna 212, incoming radar pulses transmitted by the radar system UT and received by said on-board antenna 212; and,
- when the drone 21 is located at one of the second positions,
   - delay an incoming radar pulse received by the on-board antenna 212 at said second position by a predefined time delay related to the range of the corresponding first position associated with said second position (more conveniently, a predefined time delay related to a range distance between said associated first and second positions), thereby obtaining a delayed radar pulse,
   - attenuate the delayed radar pulse by a predefined attenuation amount related to the range of the corresponding first position associated with said second position (more conveniently, a predefined attenuation amount related to the range distance between said associated first and second positions), thereby obtaining a delayed and attenuated radar pulse simulating an echo of a target located at said corresponding first position associated with said second position, and
   - provide the on-board antenna 212 with the delayed and attenuated radar pulse so that said on-board antenna 212 transmits said delayed and attenuated radar pulse towards the radar system UT.

An example of architecture suitable for the radar repeater 22 is schematically shown in Figure 6. In particular, only for the sake of illustration and description simplicity, the example of Figure 6 relates to the second test system 2b shown in Figure 4. In said example the radar repeater 22 includes:
- a switch 221 coupled to the optical fiber cable 23;
- a circulator 222, in particular a three-port circulator having a first port P1 connected to the switch 221;
- a delay module 223 connected to a second port P2 of the circulator 222;
- an attenuation module 224 connected between the delay module 224 and a third port P3 of the circulator 222; and
- a control unit 225 configured to control operation of the switch 221, the delay module 223 and the attenuation module 224.

In detail, the switch 221 is operable by the control unit 225 to connect/disconnect the first port P1 of the circulator 222 to/from the optical fiber cable 23. Specifically, the control unit 225 operates the switch 221 so as to connect the first port P1 of the circulator 222 to the optical fiber cable 23 (thereby causing the reception of the incoming radar pulses from the on-board antenna 212) only when the drone 21 is located at one of the second positions, while, when the drone 21 does not occupy anyone of the second positions, the control unit 225 keeps the first port P1 disconnected from the optical fiber cable 23.

Conveniently, the synchronization between the control unit 225 and the drone 21 can be achieved by means of:
- ad hoc signaling data/messages received from the computing device 24 or directly from the drone 21 (for example from the automatic flight management system 211 via an ad hoc signaling wired or wireless link suitably provided between said control unit 225 and said drone 21); or
- a radar repeater mission program computed by the device 24, loaded/stored on the control unit 225 and including predefined times associated with corresponding predefined time delays and attenuation amounts to be applied by, respectively, the delay module 23 and the attenuation module 224 at said predefined times.

Moreover, when the drone 21 is located at one of the second positions and, thence, when the first port P1 of the circulator 222 is connected to the optical fiber cable 23, an incoming radar signal from the on-board antenna 212 reaches the delay module 223 through the circulator 222, and the delay module applies to said incoming radar signal the predefined time delay related to the range of the corresponding first position associated with said second position (or, more conveniently, the predefined time delay related to the range distance between said associated first and second positions).

Then, the delayed radar signal reaches the attenuation module 224 and said attenuation module 224 attenuates said delayed radar signal by the predefined attenuation amount related to the range of the corresponding first position associated with said second position (or, more conveniently, the predefined attenuation amount related to the range distance between said associated first and second positions).

Conveniently, the predefined time delays intended to be applied by the delay module 223 when the drone 21 is located at the second positions, as well as the predefined attenuation amounts intended to be applied by the attenuation module 224 when the drone 21 is located at the second positions are computed by the computing device 24 before the mission of the drone 21 and, then, loaded/stored on, or provided in real time to, the control unit 225, which, during the drone's mission, controls and varies the time delays and the attenuation amounts applied to the incoming radar signals by the delay and attenuation modules 223 and 224 according to said predefined time delays and attenuation amounts loaded/stored on said control unit 225, or provided in real time thereto, by the computing device 24.

Conveniently, the computing device 24 and the radar repeater 22 are equipped with wired/wireless communication means operable to allow exchange of data/signals/messages/commands between said computing device 24 and said radar repeater 22 according to the features and functions previously described.

In the following, specific preferred features of the test systems 2a and 2b will be described in detail.

In particular, the computing device 24 is preferably programmed to compute drone mission parameters including the second trajectory and related time profile by processing at least the following input parameters:
- the position (i.e., the coordinates) of the antenna of the radar system UT;
- the position (i.e., the coordinates) of the launch point of the TBM to be simulated;
- the position (i.e., the coordinates) of the launch point of the drone 21;
- an input sampled trajectory to be simulated;
- the radar north UTC time (i.e., the time at which the boresight of the radar antenna is aimed at north);
- the take-off UTC time for the drone 21;
- the flight mode for the drone 21 according to the invention, a continuous flight mode or a stop-and-go flight mode); and
- the pulse repetition time (PRT) of the radar system UT.

The computing device 24 is programmed to carry out the following operations:
1) generating, based on the input sampled trajectory to be simulated (for example, inputted by a user and/or selected by a user from among predefined trajectories stored on an ad hoc database or on the computing device 24 itself), and on the positions of the radar antenna and of the launch points of the drone 21 and of the TBM to be simulated, a 3D trajectory originating from the launch point of said TBM to be simulated, wherein said 3D trajectory is sampled with the same sampling rate as the input sampled trajectory;
2) generating, based on the positions of the radar antenna and of the launch point of the drone 21, a flight path, which represents a projection of the 3D trajectory onto a plane closer to the radar antenna, and which is such that to cause the drone 21 to be always on the line connecting the center of the radar beams transmitted by the radar antenna and the hypothetical position of the TBM to be simulated, and almost at one and the same distance from the radar antenna (for example, at a distance of about 300 m) ;
3) transposing the flight path into the time domain, thereby computing a simulation start time corresponding to the inputted take-off UTC time, wherein this operation is based on the radar north UTC time (this information being obtainable from the radar system itself or by means of ad hoc in-field measurements);
4) re-sampling the flight path transposed in the time domain so as to obtain the aforesaid second trajectory, which is intended to be followed by the drone 21 and which includes the aforesaid second positions that are synchronized with the time instants at which the radar antenna will be aimed, in azimuth, at said second positions, wherein this operation is based on the radar north UTC time and on the simulation start time;
5) allowing a user to select a flight mode for the drone 21 from between
   - a continuous flight mode, according to which the drone 21 flies the second trajectory continuously, and
   - a stop-and-go flight mode, according to which the drone 21 stops at each second position while the radar antenna is aimed at said second position, and moves fast to the next second position while the radar antenna is aimed in other directions (in this case, the PRT of the radar system UT can be conveniently set equal to a predefined value, such as 1 second);
6) computing, based on the second trajectory and the position of the radar antenna, a heading for the drone 21 such that the on-board antenna 212 is always aimed towards the radar antenna;
7) generating and loading/storing on the automatic flight management system 211 a drone mission program including the second trajectory and the respective time profile (conveniently, in the drone mission program each second position is expressed in terms of latitude, longitude and height and is associated with the corresponding UTC time at which the drone 21 has to occupy said second position); and
8) loading/storing the drone mission program (or, equivalently, the second trajectory along with the UTC times associated with the second positions) also on the control unit 225 along with the predefined time delays and attenuation amounts to be applied by the delay and attenuation modules 223 and 224 depending on the second position occupied by the drone 21.

Then, the drone's mission starts at the simulation start time computed by the computing device 24 and comprised in the drone mission program loaded/stored on the automatic flight management system 211 of the drone 21.

As previously explained, when the drone 21 carries out the mission, said drone 21, the radar repeater 22 and the radar system UT are synchronized, whereby the delayed and attenuated radar pulses re-transmitted by the on-board antenna 212 of the drone 21 simulate a non-linear moving target distant hundreds of kilometers from the radar antenna.

In addition, an adjustment of the target Swerling models used and of the radar cross-section (RCS) can be conveniently carried out on the radar repeater 22 so as to allow to simulate targets with different features. Further details about Swerling models can be found, for example, in Merrill I. Skolnik, "Radar Handbook", McGraw-Hill, Second Edition, sections 2.21-2.23.

Conveniently, the test systems 2a and 2b can include also a portable case or bag designed to house the drone 21, the computing device 24 and, as far as the second test system 2b is concerned, also the radar repeater 22 and the optical fiber cable 23, thereby allowing an easy transportation of the test systems 2a and 2b.

It is worth stressing the point that the concepts and features explained in the foregoing with respect to the second test system 2b are applicable, mutatis mutandis, also in the case of test systems comprising, between the drone 21 and the radar repeater 22, a wired connection different than the optical fiber cable 23, or a wireless connection.

From the foregoing description the technical advantages of the present invention are immediately clear.

In particular, it is important to point out that the present invention allows to overcome the technical drawbacks of the techniques currently used to test radar systems' capability to detect and track TBMs.

Specifically, the present invention allows to:
- test the full receiving and processing chain of a radar system UT;
- test the ATBM function without altering the normal beam pointing and the normal operation of the radar system UT;
- have a full flexibility in generating different trajectories of different types of TBMs;
- obtain reliable results; and
- perform low-cost test campaigns.

Moreover, the present invention allows to reliably test, check, evaluate, validate, calibrate and improve ATBM capabilities of modern 3D radar systems.

In fact, as described in detail in the foregoing, the present invention, by exploiting a drone flying a downscaled trajectory close to the radar antenna of a radar system UT and coupled with a radar repeater generating radar echoes coherent with the position of the drone along the pre-programmed flight, allows to generate electromagnetic signals emulating radar echoes with the physical and kinematic properties of a TBM at different spatial positions within the radar coverage (including at high elevation angles). In particular, the combination of the kinematic evolution of the drone and of the delayed and attenuated echoes generated by the radar repeater allows to generate a spatial distribution of radar echoes emulating that one generated by a TBM in the execution of its trajectory.

Moreover, the present invention allows to improve the design of radar systems with ATBM capability by making available a reliable and easy technique for calibrating and testing radar systems' capabilities to detect and track ballistic missiles along their flights.

Additionally, the present invention provides also the following further technical advantages:
- high portability;
- capability to test the ATBM functions in the field, in real electromagnetic environments and scenarios, and during the normal surveillance mode of a radar system;
- capability to suitably and coherently combine the artificial TBM echoes with the real electromagnetic environment (i.e., noise, clutter, air-traffic-related signals, false plots, etc.);
- capability to test the full receiving and processing chain of a radar system;
- ease of use;
- capability to carry out tests independently of the radar system UT, requiring no real-time timing or control signals from the radar system UT for operation;
- adaptability to different radar types, operating frequencies, radiation technologies and radiation patterns (moreover, the use of the present invention is not affected by the presence of specific infrastructures, such as radomes, towers, etc.).

## Claims

1. Method for testing radar systems' capability to detect and track targets, said method comprising:
• defining a first non-linear trajectory of a non-linear moving target to be simulated, wherein said first non-linear trajectory comprises a sequence of first positions, each defined by respective range, azimuth and elevation with respect to an antenna (1) of a radar system under test;
• defining a kinematic model of the non-linear moving target to be simulated;
• computing a second non-linear trajectory based on the first non-linear trajectory, wherein said second non-linear trajectory comprises a sequence of second positions, each of which is
- defined by respective range, azimuth and elevation with respect to the antenna (1) of the radar system under test,
- associated with a corresponding first position that is defined, with respect to the antenna (1) of the radar system under test, by the same azimuth and elevation as said second position and by a greater range than said second position, and
- associated with a corresponding time at which the non-linear moving target is located at the corresponding first position associated with said second position, wherein said corresponding time is computed based on the kinematic model;
• providing a drone (21) equipped with an on-board antenna (212) for receiving radar signals transmitted by the antenna (1) of the radar system under test;
• flying the drone (21) by
- following the second non-linear trajectory, and
- causing said drone (21) to be located at each second position at the corresponding time associated with said second position; and,
• when the drone (21) is located at one of the second positions,
- processing an incoming radar signal received by the on-board antenna (212) at said second position so as to generate a processed radar signal simulating a radar echo from the non-linear moving target located at the corresponding first position associated with said second position, and
- transmitting the processed radar signal by the on-board antenna (212) from said second position towards the antenna (1) of the radar system under test;
wherein flying the drone (21) includes:
• allowing a user to select a flight mode for the drone (21) from among a continuous flight mode and a stop-and-go flight mode;
• if the continuous flight mode is selected, causing the drone (21) to follow continuously the second non-linear trajectory;
• if the stop-and-go flight mode is selected, causing the drone (21) to reach, and stop at, each second position.

2. The method of claim 1, further including computing for each second position:
• a corresponding time delay associated with said second position and related to the range of the corresponding first position associated with said second position; and
• a corresponding attenuation amount associated with said second position and related to the range of the corresponding first position associated with said second position;
and wherein processing an incoming radar signal received by the on-board antenna (212) at a second position includes:
• delaying the incoming radar signal by the corresponding time delay associated with said second position, thereby obtaining a delayed radar signal; and
• attenuating the delayed radar signal by the corresponding attenuation amount associated with said second position, thereby obtaining the processed radar signal to be transmitted by the on-board antenna (212) from said second position towards the antenna (1) of the radar system under test.

3. The method according to claim 1 or 2, wherein the non-linear moving target to be simulated is a ballistic missile.

4. The method according to any preceding claim, wherein the drone (21) is a multicopter drone.

5. System (2a;2b) for testing radar systems' capability to detect and track targets, said system (2a;2b) comprising:
• a computing device (24) programmed to
- define a first non-linear trajectory of a non-linear moving target to be simulated, wherein said first non-linear trajectory comprises a sequence of first positions, each of which is defined by respective range, azimuth and elevation with respect to an antenna (1) of a radar system under test,
- define a kinematic model of the non-linear moving target to be simulated, and
- compute a second non-linear trajectory based on the first non-linear trajectory, wherein said second non-linear trajectory comprises a sequence of second positions, each of which is
- defined by respective range, azimuth and elevation with respect to the antenna (1) of the radar system under test,
- associated with a corresponding first position that is defined, with respect to the antenna (1) of the radar system under test, by the same azimuth and elevation as said second position and by a greater range than said second position, and
- associated with a corresponding time at which the non-linear moving target is located at the corresponding first position associated with said second position, wherein said corresponding time is computed by the computing device (24) based on the kinematic model;
• a drone (21), that is equipped with an on-board antenna (212) for receiving radar signals transmitted by the antenna (1) of the radar system under test and with an automatic flight management system (211) operable to fly said drone (21) by
- following the second non-linear trajectory, and
- causing said drone (21) to be located at each second position at the corresponding time associated with said second position; and
• a radar repeater (22), that is connected to the on-board antenna (212), and that is configured to
- receive incoming radar signals transmitted by the antenna (1) of the radar system under test and received by the on-board antenna (212), and,
- when the drone (21) is located at one of the second positions,
- process an incoming radar signal received by the on-board antenna (212) at said second position so as to generate a processed radar signal simulating a radar echo from the non-linear moving target located at the corresponding first position associated with said second position, and
- transmit the processed radar signal by the on-board antenna (212) from said second position towards the antenna (1) of the radar system under test;
wherein the computing device (24) is programmed to provide or store the second non-linear trajectory and the corresponding times associated with the second positions to/on the automatic flight management system (211);
wherein the computing device (24) is programmed to allow a user to select a flight mode for the drone (21) from among a continuous flight mode and a stop-and-go flight mode;
and wherein the automatic flight management system (211) is configured to:
• if the continuous flight mode is selected, cause the drone (21) to follow continuously the second non-linear trajectory; and,
• if the stop-and-go flight mode is selected, cause the drone (21) to reach, and stop at, each second position.

6. The system of claim 5, wherein the computing device (24) is further programmed to:
• compute, for each second position,
- a corresponding time delay associated with said second position and related to the range of the corresponding first position associated with said second position, and
- a corresponding attenuation amount associated with said second position and related to the range of the corresponding first position associated with said second position; and
• provide or store the computed time delays and the computed attenuation amounts to/on the radar repeater (22);
and wherein the radar repeater (22) is configured to process an incoming radar signal received by the on-board antenna (212) at a second position by:
• delaying the incoming radar signal by the corresponding time delay associated with said second position, thereby obtaining a delayed radar signal; and
• attenuating the delayed radar signal by the corresponding attenuation amount associated with said second position, thereby obtaining the processed radar signal to be transmitted by the on-board antenna (212) from said second position towards the antenna (1) of the radar system under test.

7. The system according to claim 5 or 6, wherein the non-linear moving target to be simulated is a ballistic missile.

8. The system according to any claim 5-7, wherein the drone (21) is a multicopter drone.

9. The system according to any claim 5-8, wherein the radar repeater (22) is:
• installed on board the drone (21); or
• designed to be placed on the ground and to be connected to the on-board antenna (212) by means of a wired or wireless connection.

10. Computer program product comprising software code portions that are:
• loadable/storable on the computing device (24) of the system (2a; 2b) as claimed in any claim 5-9; and
• such that when executed to cause the computing device (24) of the system (2a;2b) to perform as defined in any claim 5-9.

## Patentansprüche

1. Verfahren zum Testen der Fähigkeit von Radarsystemen, Ziele zu erkennen und zu verfolgen, wobei das Verfahren Folgendes aufweist
• Definieren einer ersten nichtlinearen Trajektorie eines zu simulierenden sich nichtlinear bewegenden Ziels, wobei die erste nichtlineare Trajektorie eine Folge von ersten Positionen umfasst, die jeweils durch eine entsprechende Entfernung, einen Azimut und eine Elevation in Bezug auf eine Antenne (1) eines zu testenden Radarsystems definiert sind;
• Definieren eines kinematischen Modells des zu simulierenden sich nichtlinear bewegenden Ziels;
• Berechnen einer zweiten nichtlinearen Trajektorie basierend auf der ersten nichtlinearen Trajektorie, wobei die zweite nichtlineare Trajektorie eine Sequenz von zweiten Positionen aufweist, von denen jede
- durch die jeweilige Entfernung, den Azimut und die Elevation in Bezug auf die Antenne (1) des zu testenden Radarsystems definiert ist,
- mit einer entsprechenden ersten Position assoziiert ist, die in Bezug auf die Antenne (1) des zu testenden Radarsystems durch denselben Azimut und dieselbe Elevation wie die zweite Position und durch eine größere Entfernung als die zweite Position definiert ist, und
- mit einer entsprechenden Zeit assoziiert ist, zu der sich das sich nichtlinear bewegende Ziel an der entsprechenden ersten Position befindet, die mit der zweiten Position assoziiert ist, wobei die entsprechende Zeit auf der Grundlage des kinematischen Modells berechnet wird;
• Bereitstellen einer Drohne (21), die mit einer Bordantenne (212) zum Empfang von Radarsignalen ausgestattet ist, die von der Antenne (1) des zu prüfenden Radarsystems gesendet werden;
• Fliegen der Drohne (21) durch
- Folgen der zweiten nicht-linearen Flugbahn, und
- Bewirken, dass sich die Drohne (21) an jeder zweiten Position zu der mit der zweiten Position assoziierten entsprechenden Zeit befindet; und,
• wenn sich die Drohne (21) an einer der zweiten Positionen befindet,
- Verarbeiten eines ankommenden Radarsignals, das von der Bordantenne (212) an der zweiten Position empfangen wird, um ein verarbeitetes Radarsignal zu erzeugen, das ein Radarecho von dem sich nichtlinear bewegenden Ziel simuliert, das sich an der entsprechenden ersten Position befindet, die mit der zweiten Position assoziiert ist, und
- Senden des verarbeiteten Radarsignals durch die Bordantenne (212) von der zweiten Position in Richtung der Antenne (1) des zu testenden Radarsystems;
wobei das Fliegen der Drohne (21) Folgendes aufweist:
• Ermöglichen, dass ein Benutzer einen Flugmodus für die Drohne (21) aus einem kontinuierlichen Flugmodus und einem Stop-and-Go-Flugmodus auswählen kann;
• wenn der kontinuierliche Flugmodus ausgewählt wird, Bewirken, dass die Drohne (21) kontinuierlich der zweiten nicht-linearen Flugbahn folgt;
• wenn der Stop-and-Go-Flugmodus ausgewählt ist, Bewirken, dass die Drohne (21) jede zweite Position erreicht und dort anhält.

2. Verfahren nach Anspruch 1, wobei das Verfahren für jede zweite Position das Berechnen von Folgendem umfasst:
• einer entsprechenden Zeitverzögerung, die mit der zweiten Position assoziiert ist und die auf die Entfernung der entsprechenden ersten Position bezogen ist, die mit der zweiten Position assoziiert ist; und
• eines entsprechenden Dämpfungsbetrags, der mit der zweiten Position assoziiert ist und der auf die Entfernung der entsprechenden ersten Position bezogen ist, die mit der zweiten Position assoziiert ist;
und wobei das Verarbeiten eines ankommenden Radarsignals, das von der Bordantenne (212) an einer zweiten Position empfangen wird, Folgendes aufweist:
• Verzögern des ankommenden Radarsignals um die entsprechende Zeitverzögerung, die mit der zweiten Position assoziiert ist, wodurch ein verzögertes Radarsignal erhalten wird; und
• Dämpfen des verzögerten Radarsignals um den entsprechenden Dämpfungsbetrag, der mit der zweiten Position assoziiert ist, wodurch das verarbeitete Radarsignal erhalten wird, das von der Bordantenne (212) von der zweiten Position in Richtung der Antenne (1) des zu testenden Radarsystems gesendet werden soll.

3. Verfahren nach Anspruch 1 oder 2, wobei das zu simulierende sich nichtlinear bewegende Ziel ein ballistischer Flugkörper oder ein Raketengeschoss ist.

4. Verfahren nach einem der vorhergehenden Ansprüche, wobei die Drohne (21) eine Multikopter-Drohne ist.

5. System (2a; 2b) zum Testen der Fähigkeit von Radarsystemen, Ziele zu erkennen und zu verfolgen, wobei das System (2a; 2b) Folgendes aufweist:
• eine Rechenvorrichtung (24), die programmiert ist, um
- eine erste nichtlineare Trajektorie eines zu simulierenden sich nichtlinear bewegenden Ziels zu definieren, wobei die erste nichtlineare Trajektorie eine Folge von ersten Positionen aufweist, von denen jede durch eine entsprechende Entfernung, einen Azimut und eine Elevation in Bezug auf eine Antenne (1) eines zu testenden Radarsystems definiert ist,
- ein kinematisches Modell des zu simulierenden sich nichtlinear bewegenden Ziels zu definieren, und
- eine zweite nichtlineare Trajektorie auf der Grundlage der ersten nichtlinearen Trajektorie zu berechnen, wobei die zweite nichtlineare Trajektorie eine Folge von zweiten Positionen aufweist, von denen jede
- durch die jeweilige Entfernung, den Azimut und die Elevation in Bezug auf die Antenne (1) des zu testenden Radarsystems definiert ist,
- mit einer entsprechenden ersten Position assoziiert ist, die in Bezug auf die Antenne (1) des zu testenden Radarsystems durch denselben Azimut und dieselbe Elevation wie die zweite Position und durch eine größere Entfernung als die zweite Position definiert ist, und
- mit einer entsprechenden Zeit assoziiert ist, zu der sich das sich nichtlinear bewegende Ziel an der entsprechenden ersten Position befindet, die mit der zweiten Position assoziiert ist, wobei die entsprechende Zeit von der Rechenvorrichtung (24) auf der Grundlage des kinematischen Modells berechnet wird;
• eine Drohne (21), die ausgestattet ist mit einer Bordantenne (212) zum Empfangen von Radarsignalen, die von der Antenne (1) des zu testenden Radarsystems gesendet werden, und mit einem automatischen Flugmanagementsystem (211), das die Drohne (21) fliegen kann, indem es
- der zweiten nichtlinearen Flugbahn folgt, und
- bewirkt, dass sich die Drohne (21) an jeder zweiten Position zu der mit der zweiten Position assoziierten entsprechenden Zeit befindet; und
• einen Radar-Repeater (22), der mit der Bordantenne (212) verbunden ist und der konfiguriert ist zum
- Empfangen eingehender Radarsignale, die von der Antenne (1) des zu testenden Radarsystems gesendet und von der Bordantenne (212) empfangen werden, und
- wenn sich die Drohne (21) an einer der zweiten Positionen befindet,
- Verarbeiten eines ankommenden Radarsignals, das von der Bordantenne (212) an der zweiten Position empfangen wird, um ein verarbeitetes Radarsignal zu erzeugen, das ein Radarecho von dem sich nichtlinear bewegenden Ziel simuliert, das sich an der entsprechenden ersten Position befindet, die mit der zweiten Position assoziiert ist, und
- Senden des verarbeiteten Radarsignals durch die Bordantenne (212) von der zweiten Position in Richtung der Antenne (1) des zu prüfenden Radarsystems;
wobei die Rechenvorrichtung (24) so programmiert ist, dass sie die zweite nichtlineare Trajektorie und die entsprechenden Zeiten, die mit den zweiten Positionen assoziiert sind, an/auf dem automatischen Flugmanagementsystem (211) bereitstellt oder speichert;
wobei die Rechenvorrichtung (24) so programmiert ist, dass sie einem Benutzer erlaubt, einen Flugmodus für die Drohne (21) aus einem kontinuierlichen Flugmodus und einem Stop-and-Go-Flugmodus auszuwählen;
und wobei das automatische Flugmanagementsystem (211) konfiguriert ist, um:
- wenn der kontinuierliche Flugmodus ausgewählt ist, zu bewirken, dass die Drohne (21) kontinuierlich der zweiten nichtlinearen Flugbahn folgt; und
- wenn der Stop-and-Go-Flugmodus ausgewählt ist, zu bewirken, dass die Drohne (21) jede zweite Position erreicht und dort anhält.

6. System nach Anspruch 5, wobei die Rechenvorrichtung (24) ferner programmiert ist zum:
• Berechnen, für jede zweite Position,
- einer entsprechenden Zeitverzögerung, die mit der zweiten Position assoziiert ist und auf die Entfernung der entsprechenden ersten Position bezogen ist, die mit der zweiten Position assoziiert ist, und
- eines entsprechenden Dämpfungsbetrags, der mit der zweiten Position assoziiert ist und auf die Entfernung der entsprechenden ersten Position bezogen ist, die mit der zweiten Position assoziiert ist; und
• Bereitstellen oder Speichern der berechneten Zeitverzögerungen und der berechneten Dämpfungsbeträge an/auf dem Radar-Repeater (22);
und wobei der Radar-Repeater (22) konfiguriert ist, um ein ankommendes Radarsignal, das von der Bordantenne (212) an einer zweiten Position empfangen wird, zu verarbeiten durch:
• Verzögern des ankommenden Radarsignals um die entsprechende Zeitverzögerung, die mit der zweiten Position assoziiert ist, wodurch ein verzögertes Radarsignal erhalten wird; und
• Dämpfen des verzögerten Radarsignals um den entsprechenden Dämpfungsbetrag, der mit der zweiten Position assoziiert ist, wodurch das verarbeitete Radarsignal erhalten wird, das von der Bordantenne (212) von der zweiten Position in Richtung der Antenne (1) des zu testenden Radarsystems gesendet werden soll.

7. System nach Anspruch 5 oder 6, wobei das zu simulierende sich nichtlinear bewegende Ziel ein ballistischer Flugkörper oder ein Raketengeschoss ist.

8. System nach einem der Ansprüche 5 bis 7, wobei die Drohne (21) eine Multikopter-Drohne ist.

9. System nach einem der Ansprüche 5-8, wobei der Radar-Repeater (22):
• an Bord der Drohne (21) installiert ist; oder
• so konstruiert ist, dass er auf dem Boden platziert werden kann und mittels einer drahtgebundenen oder drahtlosen Verbindung mit der Bordantenne (212) verbunden werden kann.

10. Computerprogrammprodukt, das Softwarecodeabschnitte aufweist, die:
• auf die Rechenvorrichtung (24) des Systems (2a; 2b) nach einem der Ansprüche 5-9 ladbar/speicherbar sind; und
• so dass sie, wenn sie ausgeführt werden, die Rechenvorrichtung (24) des Systems (2a; 2b) veranlassen, wie in einem der Ansprüche 5-9 definiert zu arbeiten.

## Revendications

1. Procédé pour tester la capacité de systèmes radar à détecter et à suivre des cibles, ledit procédé comprenant les étapes suivantes :
• définir une première trajectoire non linéaire d'une cible mobile non linéaire à simuler, dans lequel ladite première trajectoire non linéaire comprend une séquence de premières positions, chacune étant définie par une portée, un azimut et une élévation respectifs par rapport à une antenne (1) d'un système radar à l'essai ;
• définir un modèle cinématique de la cible mobile non linéaire à simuler ;
• calculer une deuxième trajectoire non linéaire sur la base de la première trajectoire non linéaire, dans lequel ladite deuxième trajectoire non linéaire comprend une séquence de deuxièmes positions, dont chacune est
- définie par une portée, un azimut et une élévation respectifs par rapport à l'antenne (1) du système radar à l'essai,
- associée à une première position correspondante qui est définie, par rapport à l'antenne (1) du système radar à l'essai, par le même azimut et la même élévation que ladite deuxième position et par une plus grande portée que ladite deuxième position, et
- associée à un temps correspondant auquel la cible mobile non linéaire est située à la première position correspondante associée à ladite deuxième position, dans lequel ledit temps correspondant est calculé sur la base du modèle cinématique ;
• fournir un drone (21) équipé d'une antenne embarquée (212) pour recevoir des signaux radar transmis par l'antenne (1) du système radar à l'essai ;
• faire voler le drone (21) en
- suivant la deuxième trajectoire non linéaire, et
- amenant ledit drone (21) à être situé à chaque deuxième position au temps correspondant associé à ladite deuxième position ; et
• lorsque le drone (21) est situé à l'une des deuxièmes positions,
- traiter un signal radar entrant reçu par l'antenne embarquée (212) à ladite deuxième position de manière à générer un signal radar traité simulant un écho radar provenant de la cible mobile non linéaire située à la première position correspondante associée à ladite deuxième position, et
- transmettre le signal radar traité par l'antenne embarquée (212) depuis ladite deuxième position vers l'antenne (1) du système radar à l'essai ;
dans lequel le fait de faire voler le drone (21) comporte les étapes suivantes :
• permettre à un utilisateur de sélectionner un mode de vol pour le drone (21) parmi un mode de vol continu et un mode de vol stop-and-go ;
• si le mode de vol continu est sélectionné, amener le drone (21) à suive en continu la deuxième trajectoire non linéaire ;
• si le mode de vol stop-and-go est sélectionné, amener le drone (21) à atteindre chaque deuxième position et s'y arrêter.

2. Procédé de la revendication 1, comportant en outre le calcul pour chaque deuxième position :
• d'une temporisation correspondante associée à ladite deuxième position et liée à la portée de la première position correspondante associée à ladite deuxième position ; et
• d'une quantité d'atténuation correspondante associée à ladite deuxième position et liée à la portée de la première position correspondante associée à ladite deuxième position ;
et dans lequel le traitement d'un signal radar entrant reçu par l'antenne embarquée (212) à une deuxième position comporte les étapes suivantes :
• retarder le signal radar entrant par la temporisation correspondante associée à ladite deuxième position, obtenant ainsi un signal radar retardé ; et
• atténuer le signal radar retardé par la quantité d'atténuation correspondante associée à ladite deuxième position, obtenant ainsi le signal radar traité à transmettre par l'antenne embarquée (212) depuis ladite deuxième position vers l'antenne (1) du système radar à l'essai.

3. Procédé selon la revendication 1 ou 2, dans lequel la cible mobile non linéaire à simuler est un missile balistique.

4. Procédé selon l'une quelconque des revendications précédentes, dans lequel le drone (21) est un drone multicoptère.

5. Système (2a ; 2b) pour tester la capacité de systèmes radar à détecter et à suivre des cibles, ledit système (2a ; 2b) comprenant :
• un dispositif de calcul (24) programmé pour
- définir une première trajectoire non linéaire d'une cible mobile non linéaire à simuler, dans lequel ladite première trajectoire non linéaire comprend une séquence de premières positions, dont chacune est définie par une portée, un azimut et une élévation respectifs par rapport à une antenne (1) d'un système radar à l'essai,
- définir un modèle cinématique de la cible mobile non linéaire à simuler, et
- calculer une deuxième trajectoire non linéaire sur la base de la première trajectoire non linéaire, dans lequel ladite deuxième trajectoire non linéaire comprend une séquence de deuxièmes positions, dont chacune est
- définie par une portée, un azimut et une élévation respectifs par rapport à l'antenne (1) du système radar à l'essai,
- associée à une première position correspondante qui est définie, par rapport à l'antenne (1) du système radar à l'essai, par le même azimut et la même élévation que ladite deuxième position et par une plus grande portée que ladite deuxième position, et
- associée à un temps correspondant auquel la cible mobile non linéaire est située à la première position correspondante associée à ladite deuxième position, dans lequel ledit temps correspondant est calculé par le dispositif de calcul (24) sur la base du modèle cinématique ;
• un drone (21), qui est équipé d'une antenne embarquée (212) pour recevoir des signaux radar transmis par l'antenne (1) du système radar à l'essai et d'un système de gestion de vol automatique (211) fonctionnant pour faire voler ledit drone (21) en
- suivant la deuxième trajectoire non linéaire, et
- amenant ledit drone (21) à être situé à chaque deuxième position au temps correspondant associé à ladite deuxième position ; et
• un répéteur de radar (22), qui est connecté à l'antenne embarquée (212), et qui est configuré pour
- recevoir des signaux radar entrants transmis par l'antenne (1) du système radar à l'essai et reçus par l'antenne embarquée (212), et,
- lorsque le drone (21) est situé à l'une des deuxièmes positions,
- traiter un signal radar entrant reçu par l'antenne embarquée (212) à ladite deuxième position de manière à générer un signal radar traité simulant un écho radar depuis la cible mobile non linéaire située à la première position correspondante associée à ladite deuxième position, et
- transmettre le signal radar traité par l'antenne embarquée (212) depuis ladite deuxième position vers l'antenne (1) du système radar à l'essai ;
dans lequel le dispositif de calcul (24) est programmé pour fournir la deuxième trajectoire non linéaire et les temps correspondants associés aux deuxièmes positions au système de gestion de vol automatique (211) ou les stocker sur celui- ci ;
dans lequel le dispositif de calcul (24) est programmé pour permettre à un utilisateur de sélectionner un mode de vol pour le drone (21) parmi un mode de vol continu et un mode de vol stop-and-go ;
et dans lequel le système de gestion de vol automatique (211) est configuré pour :
• si le mode de vol continu est sélectionné, amener le drone (21) à suive en continu la deuxième trajectoire non linéaire ; et
• si le mode de vol stop-and-go est sélectionné, amener le drone (21) à atteindre chaque deuxième position et s'y arrêter.

6. Système de la revendication 5, dans lequel le dispositif de calcul (24) est en outre programmé pour :
• calculer, pour chaque deuxième position,
- une temporisation correspondante associée à ladite deuxième position et liée à la portée de la première position correspondante associée à ladite deuxième position, et
- une quantité d'atténuation correspondante associée à ladite deuxième position et liée à la portée de la première position correspondante associée à ladite deuxième position ; et
• fournir les temporisations calculées et les quantités d'atténuation calculées au répéteur de radar (22) ou les ou stocker sur celui- ci ;
et dans lequel le répéteur de radar (22) est configuré pour traiter un signal radar entrant reçu par l'antenne embarquée (212) à une deuxième position en :
• retardant le signal radar entrant par la temporisation correspondante associée à ladite deuxième position, obtenant ainsi un signal radar retardé ; et
• atténuant le signal radar retardé par la quantité d'atténuation correspondante associée à ladite deuxième position, obtenant ainsi le signal radar traité à transmettre par l'antenne embarquée (212) depuis ladite deuxième position vers l'antenne (1) du système radar à l'essai.

7. Système selon la revendication 5 ou 6, dans lequel la cible mobile non linéaire à simuler est un missile balistique.

8. Système selon l'une quelconque des revendications 5 à 7, dans lequel le drone (21) est un drone multicoptère.

9. Système selon l'une quelconque des revendications 5 à 8, dans lequel le répéteur de radar (22) est :
• installé à bord du drone (21) ; ou
• conçu pour être placé au sol et pour être connecté à l'antenne embarquée (212) par au moyen d'une connexion filaire ou sans fil.

10. Produit de programme informatique comprenant des parties de code logiciel qui sont :
• chargeables/stockables sur le dispositif de calcul (24) du système (2a ; 2b) tel que revendiqué dans l'une quelconque des revendications 5 à 9 ; et
• de sorte que, lorsqu'elles sont exécutées, elles amènent le dispositif de calcul (24) du système (2a ; 2b) à fonctionner comme défini dans l'une quelconque des revendications 5 à 9.
